# EUROPEAN PATENT APPLICATION

(11) **EP 4 645 384 A1**
(43) Date of publication of application: **05.11.2025**
(21) Application number: 25156877.0
(22) Date of filing: 10.02.2025
(51) Int. Cl.: H01L 23/48

(54) **TRANSPORT APPARATUS FOR SEMICONDUCTOR MANUFACTURING**

(30) Priority: 24.04.2024 KR 20240054655
(71) Applicant: Hyundai Mobis Co., Ltd., Gangnam-gu Seoul 06141 (KR)
(72) Inventor: JUNG, Ki Myeong, 28120 Cheongju-si (KR); JOUNG, Chul Hwan, 28124 Cheongju-si (KR); KIM, Jong Duk, 18026 Pyeongtaek-si (KR)
(74) Representative: Vossius & Partner Patentanwälte Rechtsanwälte mbB

(57) **Abstract**

A transfer apparatus for semiconductor manufacturing, the transfer apparatus including: a carrier configured to move; a substrate disposed on the carrier; a guide jig disposed above an upper surface of the substrate, the guide jig including a plurality of partition walls and a plurality of accommodation guide holes partitioned by the plurality of partition walls; and a preform solder disposed on the upper surface of the substrate, the preform solder including a plurality of bent portions, wherein the plurality of bent portions include a first bent portion formed adjacent to one end of a body; and a second bent portion formed adjacent to the other end of the body.

## Description

### CROSS-REFERENCE TO RELATED APPLICATIONS

The present application claims priority to Patent Application No. 10-2024-0054655, filed on April 24, 2024 in Korea, the entire contents of which are incorporated herein by reference.

### TECHNICAL FIELD

The present disclosure relates to a transfer apparatus for semiconductor manufacturing.

### BACKGROUND

The content described in this section simply provides background information for the present disclosure and does not constitute the related art.

A semiconductor is a key component in electronic devices. The semiconductor is used in most electronic devices in modern society, such as computers, smartphones, televisions, automobiles, and home appliances. The semiconductor is playing a key role in technological development in various technology fields of a 4th Industrial Revolution, such as artificial intelligence (AI), Internet of Things (IoT), autonomous driving or self-driving, electric vehicles, and large language models (LLM), and the importance of the semiconductor and technology fields in which the semiconductors are used are expected to increase in the future.

Power semiconductor devices are used in various fields of application technologies such as electric vehicles, industrial inverters, and solar technologies. The power semiconductor devices include metal oxide semiconductor field effect transistors (MOSFETs), insulated gate bipolar transistors (IGBTs), diodes, triacs, and the like.

A semiconductor manufacturing process includes a front end process for manufacturing a semiconductor device, and a back end process for packaging the manufactured device.

The front-end process for the power semiconductor includes a process of soldering a semiconductor device or the like on a substrate.

Before soldering is performed, a preform solder is moved by a conveyor in a state where the preform solder is stacked on the substrate together with other components. For example, the preform solder and the semiconductor devices are moved by the conveyor in a state where the preform solder and the semiconductor devices are sequentially stacked on the substrate. Soldering is performed after the preform solder and the semiconductor devices are moved by the conveyor. In this case, the preform solder and portions in contact with the preform solder are coupled with each other by the soldering.

There are various causes and types of soldering defects. One of main causes of soldering defect is a preform solder separation phenomenon. The preform solder separation phenomenon refers to a phenomenon in which a preform solder is separated from a designated position and/or a designated space due to inertia in a movement process using the conveyor described above. More types of preform solder separation phenomena will be described later.

As described above, since various components such as semiconductor devices may be stacked on the preform solder, it is not easy to visually ascertain whether or not the preform solder separation phenomenon has occurred due to the movement using the conveyor.

When soldering is performed after the preform solder separation phenomenon occurs, various types of soldering defects may occur, such as a defect in which a component is bonded to a place deviating from a designated position, a defect in which a component is separated because the component is not correctly attached to the substrate, a defect in which a component is not attached to a substrate.

There is a need for an apparatus and/or method capable of preventing the preform solder separation phenomenon from occurring.

### SUMMARY

Therefore, the present disclosure is intended to solve these problems, and a main purpose of the present disclosure is to provide a transfer apparatus capable of preventing soldering defects.

A main purpose is to prevent soldering defects by preventing a preform solder separation phenomenon and improve a yield of power semiconductor production.

The problems to be solved by the present disclosure are not limited to the above-mentioned problems, and other problems not mentioned will be clearly understood by those skilled in the art from the following description.

A transfer apparatus for semiconductor manufacturing, the transfer apparatus comprising: a carrier configured to move; a substrate disposed on the carrier; a guide jig disposed above an upper surface of the substrate, the guide jig including a plurality of partition walls and a plurality of accommodation guide holes partitioned by the plurality of partition walls; and a preform solder disposed on the upper surface of the substrate, the preform solder including a plurality of bent portions, wherein the plurality of bent portions include a first bent portion formed adjacent to one end of a body; and a second bent portion formed adjacent to the other end of the body.

As described above, according to the present embodiment, there is an effect that the transfer apparatus for semiconductor manufacturing can prevent soldering defects.

Further, there is an effect that it is possible to prevent soldering defects by preventing a preform solder separation phenomenon, and improve a yield of power semiconductor production.

### BRIEF DESCRIPTION OF THE DRAWINGS

FIG. 1 is a view illustrating a transfer apparatus for semiconductor manufacturing according to a first embodiment of the present invention before soldering is performed.
FIG. 2 is a cross-sectional view taken along line A-A' of FIG. 1.
FIG. 3 is a diagram illustrating a transfer apparatus for semiconductor manufacturing according to a second embodiment of the present invention.
FIG. 4 is a diagram illustrating an exploded perspective view of main components of the transfer apparatus for semiconductor manufacturing according to the second embodiment of the present invention.
FIG. 5A is a cross-sectional view taken along line B-B' of FIG. 3.
FIG. 5B is an enlarged view of a circular portion of FIG. 5A.
FIG. 6A is a cross-sectional view taken along line C-C' of FIG. 3.
FIG. 6B is an enlarged view of a circular portion of FIG. 6A.
FIGS. 7A to 7D are diagrams schematically illustrating various embodiments of a preform solder according to the present invention.
FIG. 8 is a perspective view illustrating a bending apparatus for manufacturing the preform solder of FIG. 7A.
FIG. 9 is a cross-sectional view illustrating a process of manufacturing a preform solder in the bending apparatus of FIG. 8.

### DETAILED DESCRIPTION

Hereinafter, some exemplary embodiments of the present disclosure will be described in detail with reference to the accompanying drawings. In the following description, like reference numerals preferably designate like elements, although the elements are shown in different drawings. Further, in the following description of some embodiments, a detailed description of known functions and configurations incorporated therein will be omitted for the purpose of clarity and for brevity.

Additionally, various terms such as first, second, A, B, (a), (b), etc., are used solely to differentiate one component from the other but not to imply or suggest the substances, order, or sequence of the components. Throughout this specification, when a part 'includes' or 'comprises' a component, the part is meant to further include other components, not to exclude thereof unless specifically stated to the contrary. The terms such as 'unit', 'module', and the like refer to one or more units for processing at least one function or operation, which may be implemented by hardware, software, or a combination thereof.

Each element of the apparatus or method in accordance with the present invention may be implemented in hardware or software, or a combination of hardware and software. The functions of the respective elements may be implemented in software, and a microprocessor may be implemented to execute the software functions corresponding to the respective elements.

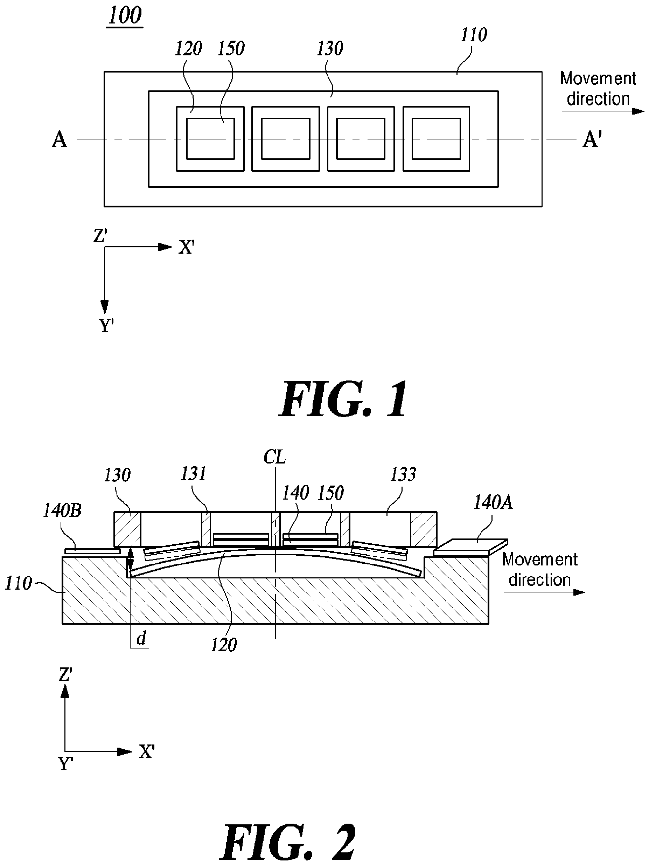

FIG. 1 is a view illustrating a transfer apparatus for semiconductor manufacturing according to a first embodiment of the present invention before soldering is performed.

FIG. 2 is a cross-sectional view taken along line A-A' of FIG. 1.

An x'-axis, a y'-axis, and a z'-axis illustrated in FIGS. 1 and 2 represent directions perpendicular to each other. Here, the x'-axis and the y'-axis represent different horizontal directions, and the z'-axis represents a vertical direction (height direction).

FIG. 1 is a plan view of a transfer apparatus 100 for semiconductor manufacturing according to the first embodiment of the present disclosure, and FIG. 2 is a front view of the transfer apparatus 100 for semiconductor manufacturing, and is a cross-sectional view taken along line A-A' of FIG. 1.

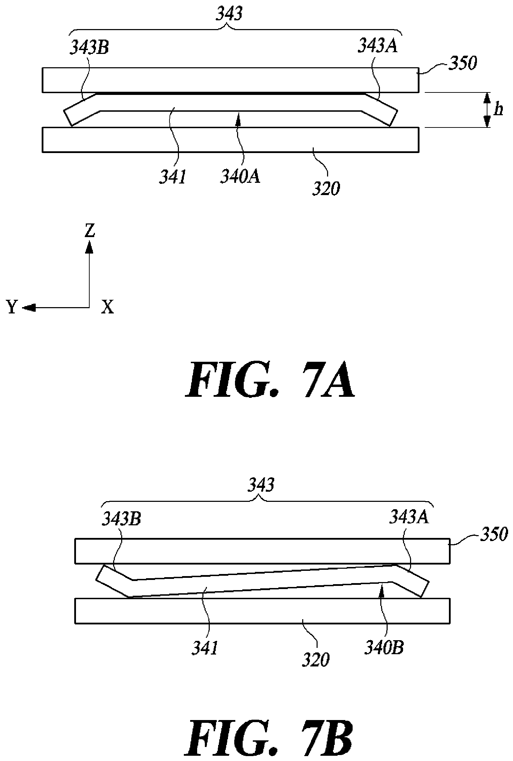

Referring to FIGS. 1 and 2, the transfer apparatus 100 for semiconductor manufacturing according to the first embodiment of the present disclosure (hereinafter referred to as a 'transfer apparatus') may include a carrier 110, a substrate 120, the guide jig 130, a preform solder 140, and various components 150 disposed on an upper surface of the preform solder 140. In the first embodiment, it is also possible to use various embodiments of a preform solder 340A, 340B, 340C or 340D shown in FIGS. 7A to 7D rather than the preform solder 140 shown in FIG. 2, as will be described later.

Since a position, size, shape, or the like of each component of the transfer apparatus 100 according to the first embodiment shown in FIGS. 1 and 2 is only one example, the transfer apparatus 100 according to the first embodiment of the present disclosure should not be construed to be limited by the drawings. In particular, the preform solder 140 of which a body is not bent is shown in FIG. 2 for convenience of description, but in the transfer apparatus 100 according to the first embodiment, various embodiments of the preform solder 340A, 340B, 340C or 340D (FIGS. 7A to 7D) including a plurality of bent portions 343 can be disposed as many times as desired, unlike that shown in FIG. 2.

The carrier 110 is configured to be moved by a conveyor (not shown). The carrier 110 may be disposed on the conveyor. The carrier 110 moves in an x'-axis direction, as shown in FIGS. 1 and 2. When the carrier 110 starts to move from a stopped state and when the carrier 110 starts to stop from a movement state, an inertial force acts on each component of the transfer apparatus 100.

Since the carrier 110 also serves to transport materials for semiconductor manufacturing before soldering is performed, the carrier 110 is referred to as a soldering carrier.

A groove portion may be formed in the carrier 110. The substrate 120 may be disposed in the groove portion.

A portion of the carrier 110 and a portion of the guide jig 130 are spaced apart from each other. In FIG. 2, a shape of a portion where the carrier 110 and the guide jig 130 are sp aced apart from each other is represented by a gap d. That is, each of a plurality of partition walls 131 and the substrate 120 may be spaced apart from each other in a vertical direction (a height direction; z'-axis) to form a gap d.

Although details are not shown in FIGS. 1 and 2 for convenience of description, a portion of the guide jig 130 is coupled to the carrier 110 using a coupling member such as a screw or a pin. According to such coupling, a relative position of the guide jig 130 with respect to the carrier 110 may be fixed to be constant.

The substrate 120 may be disposed in the groove portions of the carrier 110. The substrate 120 described in the present specification is a concept including all various types of substrates used in the semiconductor manufacturing process. For example, the substrate 120 may be a direct bonded copper (DBC) substrate that is used in a power semiconductor power module.

The substrate 120 may have a flat shape.

The substrate 120 may be bent as shown in FIG. 2. Specifically, a perfectly flat substrate 120 is difficult to be present in reality. Generally, the substrate 120 is bent to some extent. A type in which the substrate 120 is bent may include a smile, a crying, and the like. In FIG. 2, a crying type substrate 120 is shown. The crying type is a type in which a central portion of the substrate 120 is bent to be convex upwards (the z'-axis). The smile type is a type in which the central portion of the substrate 120 is bent to be convex downwards (z'-axis). In FIG. 2, a degree of bending of the substrate 120 is expressed somewhat exaggerated. Since this is for the description of the crying type, the degree of bending of the substrate 120, a degree of inclination of the substrate 120, positions of the component 150 and the preform solder 140, a disposition angle of the preform solder 140, and the like are not limited to FIG. 2.

The preform solders 140, 340A, 340B, 340C or 340D and the various components 150 such as and semiconductor devices may be disposed on an upper surface of the substrate 120.

The guide jig 130 may be disposed above the upper surface of the substrate 120.

The guide jig 130 may include a plurality of partition walls 131. The plurality of partition walls 131 partition a plurality of accommodation guide holes 133. For example, in FIG. 2, four accommodation guide holes 133 partitioned by the plurality of partition walls 131 are shown. The preform solders 140, 340A, 340B, 340C or 340D are disposed on the upper surface of the substrate 120 through the accommodation guide holes 133. The plurality of accommodation guide holes 133 guide the preform solders 140, 340A, 340B, 340C or 340D and the like so that the preform solders 140, 340A, 340B, 340C or 340D and the component 150 can be stacked at determined positions.

As described above, most of the substrates 120 are bent. When the preform solders 140, 340A, 340B, 340C or 340D and the like are disposed on the upper surface of the substrate 120 in a state where the guide jig 130 is not disposed, the preform solders 140, 340A, 340B, 340C or 340D may be separated from pre-designated positions and/or the accommodation guide holes 133 by the bent slope of the substrate 120. For example, the preform solders 140, 340A, 340B, 340C or 340D may slide along the inclination of the substrate 120. Therefore, the guide jig 130 is disposed above the substrate 120 before the preform solders 140, 340A, 340B, 340C or 340D are disposed, and then the preform solders 140, 340A, 340B, 340C or 340D are inserted into the accommodation guide holes 133 and disposed on the substrate 120. Thus, the partition wall 131 of the guide jig 130 restricts positions of the preform solders 140, 340A, 340B, 340C or 340D so that the preform solders 140, 340A, 340B, 340C or 340D are not separated from the determined positions.

In the present specification, the preform solder separation phenomenon includes that the preform solder is separated from pre-designated positions due to inertia generated by a movement (starting and stopping) of the carrier 110, that the preform solder is separated from the pre-designated positions due to an inclination of the bent substrate 120, that the preform solder is separated from the pre-designated positions by passing through the gap d (FIG. 2) between the substrate 120 and the guide jig 130, that the preform solder is separated from the pre-designated positions due to vibration and/or impact acting on the transfer apparatus for semiconductor manufacturing, and the like. An example of the preform solder 140A and 140B in which a separation phenomenon has occurred is illustrated in FIG. 2. That is, the preform solder indicated by a broken line in FIG. 2 has escaped through the gap d (140A or 140B). In the crying type substrate 120, the gap d between the substrate 120 and the guide jig 130 tends to increase toward both ends of the substrate 120 and decrease toward a center of the substrate 120.

When soldering is performed after the preform solder separation phenomenon occurs, various types of soldering defects may occur, such as a defect in which the component 150 that is a soldering target is bonded to a place other than a designated position, a defect in which the component 150 is separated because the component 150 is not correctly attached to the substrate 120, and a defect in which the component 150 is not attached to the substrate 120.

Before soldering is performed, one of the various types of components 150, such as an IGBT, is stacked on the upper surface of the preform solder, and the carrier 110 moves with the component 150 stacked on the upper surface of the preform solder. Since the component 150 stacked on the upper surface of the preform solder blocks the field of view, it is difficult to ascertain whether the preform solder separation phenomenon occurs due to the movement of the carrier 110. For example, since the component 150 blocks the field of view of the preform solders 140 in FIG. 1, it is difficult to confirm whether the preform solder 140A and 140B are separated from the pre-designated positions as in FIG. 2. In FIG. 2, an example of the preform solder 140A and 140B separated from the accommodation guide holes 133 through the gap d is represented. When the preform solder 140A of which the body is not bent as shown in FIG. 2 is used, the preform solder 140A and 140B may are separated through the gap d.

The transfer apparatuses 100 and 300 according to various embodiments of the present disclosure may use any one of various types of preform solders 140, 340A, 340B, 340C or 340D.

For example, the preform solder 140 in which the body is not bent, which is shown in FIG. 2, may be used for the transfer apparatuses 100 and 300 according to various embodiments of the present invention. For example, the preform solders 340A, 340B, 340C or 340D, each including the plurality of bent portions shown in FIG. 7A to FIG. 7D may be used for the transfer apparatuses 100 and 300 according to various embodiments of the present invention. Each type of preform solder including the plurality of bent portions 343 will be described later.

The various components 150 may be disposed on the upper surfaces of the preform solders 140, 340A, 340B, 340C or 340D. For example, the components 150 disposed on the upper surfaces of the preform solders 140, 340A, 340B, 340C or 340D may be various semiconductor devices. For example, the components 150 disposed on the upper surfaces of the preform solders 140, 340A, 340B, 340C or 340D may be insulated gate bipolar transistors (IGBTs). For example, the component 150 disposed on the upper surfaces of the preform solders 140, 340A, 340B, 340C or 340D may be spacers. For example, the components 150 disposed on the upper surfaces of the preform solders 140, 340A, 340B, 340C or 340D may be other substrates.

Hereinafter, it is assumed that the transfer apparatus (100) uses the preform solder, such as those shown in FIGS. 7A to 7D, including the plurality of bent portions 343, rather than using the preform solder 140 with an unbent body.

Since the transfer apparatuses 100 and 300 for semiconductor manufacturing according to various embodiments of the present invention may use the preform solder (FIGS. 7A to 7D) including the plurality of bent portions 343, the preform solder separation phenomenon does not occur. The preform solders 140A and 140B shown in FIG. 2 are only intended for description of an example of the preform solder separation phenomenon, and when the preform solder shown in FIGS. 7A to 7D is used in the transfer apparatus 100 according to the first embodiment, the preform solder separation phenomenon does not occur in the transfer apparatus 100 according to the first embodiment. That is, it should not be mistaken that the transfer apparatus 100 according to the first embodiment cannot prevent the preform solder separation phenomenon according to FIG. 2.

When the substrate 120 and the guide jig 130 are first disposed on the carrier 110, and then the preform solder including the plurality of bent portions 343, as shown in FIGS. 7A to 7D is disposed inside the accommodation guide hole 133, the preform solder separation phenomenon is prevented by the partition wall 131 of the guide jig 130.

That is, the guide jig 130 includes the accommodation guide hole 133 and the partition walls 131 and serves to fix the preform solder 340A, 340B, 340C or 340D and the components 150 stacked on the preform solder 340A, 340B, 340C or 340D are not separated from the determined positions. A stacked structure (preform solders, semiconductor devices, and the like) stacked on the upper surface of the substrate 120 is not easily twisted by the partition walls 131 of the guide jig 130. Even when inertia acts due to the movement of the carrier 110, the preform solder 340A, 340B, 340C or 340D is blocked by the partition walls 131 and does not are separated from the accommodation guide hole 133 and/or the designated position. This is because the preform solder 340A, 340B, 340C or 340D including the plurality of bent portions has a structure that the preform solder 340A, 340B, 340C or 340D is easily blocked by the partition walls 131 since the preform solder 340A, 340B, 340C or 340D has a larger height in a vertical direction (height direction) than the preform solder 140 of which the body is not bent.

That is, even when an external force acts on the transfer apparatus 100 according to the first embodiment or inertia due to the movement of the carrier 110 acts on the transfer apparatus 100 according to the first embodiment, a stacked structure (the preform solder, the semiconductor device, and the like) does not twist.

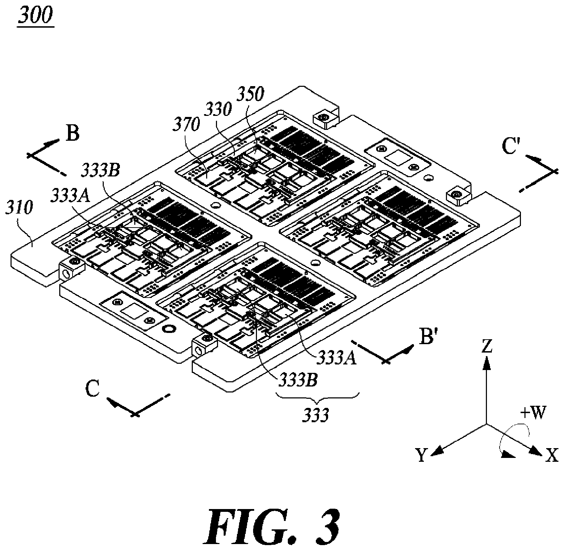

FIG. 3 is a diagram illustrating a transfer apparatus for semiconductor manufacturing according to a second embodiment of the present invention.

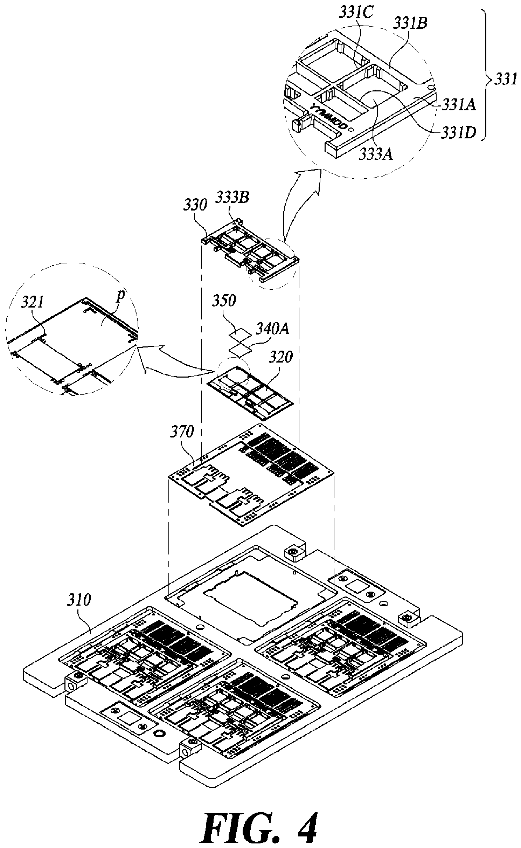

FIG. 4 is a diagram illustrating an exploded perspective view of main components of the transfer apparatus for semiconductor manufacturing according to the second embodiment of the present invention.

An x-axis, a y-axis, and a z-axis shown in FIGS. 3, 5, and 6 represent directions perpendicular to each other. The x-axis and the y-axis represent different horizontal directions. The z-axis represents a vertical direction (height direction).

Referring to FIGS. 3 and 4, a transfer apparatus 300 for semiconductor manufacturing (hereinafter, referred to as a 'transfer apparatus') according to the second embodiment of the present disclosure may include a carrier 310, a substrate 320, a guide jig 330, preform solders 140, 340A, 340B, 340C or 340D, various components 350 and a lead frame 370 disposed on upper surfaces of the preform solders 140, 340A, 340B, 340C or 340D, and the like. In the transfer apparatus 300 according to the second embodiment, as the preform solder, any one of the preform solder 140 of which the body is not bent and the preform solder 340A, 340B, 340C or 340D including the plurality of bent portions 343 may be selectively used, but since the use of the preform solder 340A, 340B, 340C or 340D including the plurality of bent portions 343 is more effective in preventing the preform solder separation phenomenon, the following description will be given on the premise that the transfer apparatus 300 according to the second embodiment uses the preform solder 340A, 340B, 340C or 340D including the plurality of bent portions 343.

Since a position, size, and shape of each component of the transfer apparatus 300 according to the second embodiment shown in FIGS. 3 and 4 are only one example, the transfer apparatus 300 according to the second embodiment of the present disclosure should not be construed to be limited by the drawings.

The carrier 310 is configured to be moved by a conveyor (not shown). The carrier 310 may be disposed on the conveyor. The carrier 310 moves along an x-axis direction (FIGS. 3, 5, and 6). When the carrier 310 starts to move from a stopped state and when the carrier 310 starts to stop from a movement state, an inertial force acts on each component of the transfer apparatus 300.

A plurality of groove portions may be formed in the carrier 310. The lead frame 370, the substrate 320, and the like may be disposed in the respective groove portions of the plurality of groove portions of the carrier 310.

The guide jig 330 may be coupled to the carrier 310 using a coupling member such as a screw, and a relative position of the guide jig 330 with respect to the carrier 310 may be fixed to be constant according to the coupling.

The substrate 320 may be disposed in any one of the plurality of groove portions of the carrier 310. The substrate 320 described in the present specification has a concept including all of various types of substrates used in the semiconductor manufacturing process. For example, the substrate 320 may be a direct bonded copper (DBC) substrate used in a power semiconductor power module.

The substrate 320 may have a flat shape. Alternatively, the substrate 320 may be bent like the substrate 120 of FIG. 2. Types in which the substrate 320 is bent include a smile, a crying, and the like. The crying type is a type in which the substrate 320 is bent to be convex upwards (the z-axis in FIG. 3). The smile type is a type in which the substrate 320 is bent to be convex downwards (z-axis in FIG. 3).

The guide jig 330 may be disposed above the upper surface of the substrate 320.

After the guide jig 330 is disposed above the upper surface of the substrate 320, the preform solder 340A, 340B, 340C or 340D and the components 350 may be disposed on the upper surface of the substrate 320. The components 350 may be various semiconductor devices. The components 350 may be an IGBT or the like.

The substrate 320 may include a plurality of dimples 321. The plurality of dimples 321 may be formed to penetrate the upper and lower surfaces of the substrate 320 in the z-axis direction (FIG. 3) or may be formed to be recessed on the upper surface of the substrate 320.

A plurality of dimples 321 may be disposed to form a predetermined arrangement. For example, the plurality of dimples 321 may be disposed adjacent to an inner surface of the accommodation guide hole 333. For example, the plurality of dimples 321 may be disposed to surround the preform solder 340A, 340B, 340C or 340D. That is, the plurality of dimples 321 may be disposed to surround a disposition area P. The disposition area P is an area of the upper surface of the substrate 320 and refers to a position designated so that the preform solder 340A, 340B, 340C or 340D is stacked. When the preform solder 340A, 340B, 340C or 340D is separated from the disposition area P, various types of soldering defects may occur. In the transfer apparatuses 100 and 300 according to various embodiments of the present invention, the preform solder 340A, 340B, 340C or 340D is not separated from the disposition area P due to an interaction between the preform solder 340A, 340B, 340C or 340D and the guide jig 330. That is, the preform solder separation phenomenon does not occur. The disposition area P described above is merely an example, and a position of the disposition area P is not limited by the illustration of the drawing.

The guide jig 330 may be disposed above the upper surface of the substrate 320. The guide jig 330 may include a plurality of partition walls 331, a plurality of accommodation guide holes 333, and the like. The plurality of partition walls 331 partition the plurality of accommodation guide holes 333. For example, a plurality of accommodation guide holes 333 partitioned by the plurality of partition walls 331 are shown in FIG. 4. For example, a first accommodation guide hole 333A partitioned by a first partition wall 331A to a fourth partition wall 331D is shown in FIG. 4. For example, a second accommodation guide hole 333B or the like is shown in FIG. 4.

The preform solder 340A, 340B, 340C or 340D is disposed on the upper surface of the substrate 320 through the plurality of accommodation guide holes 333. The plurality of accommodation guide holes 333 guide the preform solder 340A, 340B, 340C or 340D, the component 350, and the like so that the preform solder 340A, 340B, 340C or 340D and the component 350 can be stacked at the determined positions.

As described above, most of the substrates 320 are bent. When the preform solder 340A, 340B, 340C or 340D or the like is disposed on the upper surface of the substrate 320 in a state where the guide jig 330 is not disposed, the preform solder 340A, 340B, 340C or 340D may be separated from the disposition area P due to the inclination of the bent substrate 320. For example, the preform solders 140, 340A, 340B, 340C or 340D may slide along the inclination of the substrate 320. Therefore, before the preform solder 340A, 340B, 340C or 340D is disposed, the guide jig 330 is disposed above the substrate 320, and then the preform solder 340A, 340B, 340C or 340D is inserted into the accommodation guide hole 333 and the preform solder 340A, 340B, 340C or 340D is disposed on the substrate 320. The partition wall 331 of the guide jig 330 restricts a position of the preform solder 340A, 340B, 340C or 340D so that the preform solder 340A, 340B, 340C or 340D does not are separated from the disposition area P and/or the determined position.

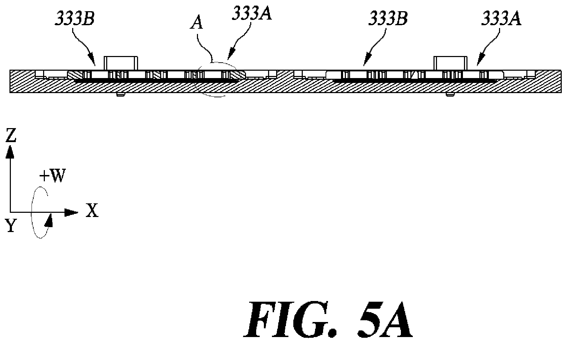

FIG. 5A is a cross-sectional view taken along line B-B' of FIG. 3.

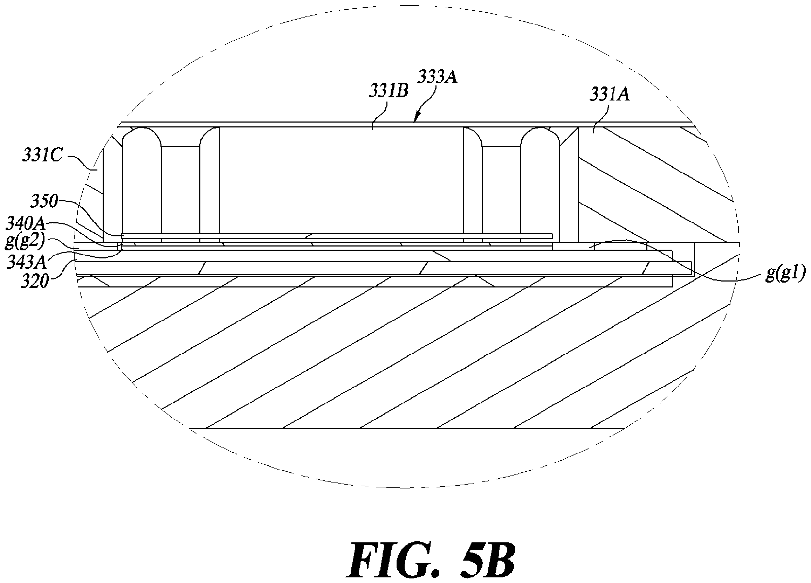

FIG. 5B is an enlarged view of a circular portion of FIG. 5A.

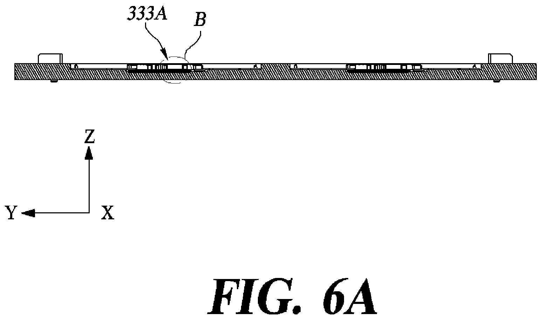

FIG. 6A is a cross-sectional view taken along line C-C' of FIG. 3.

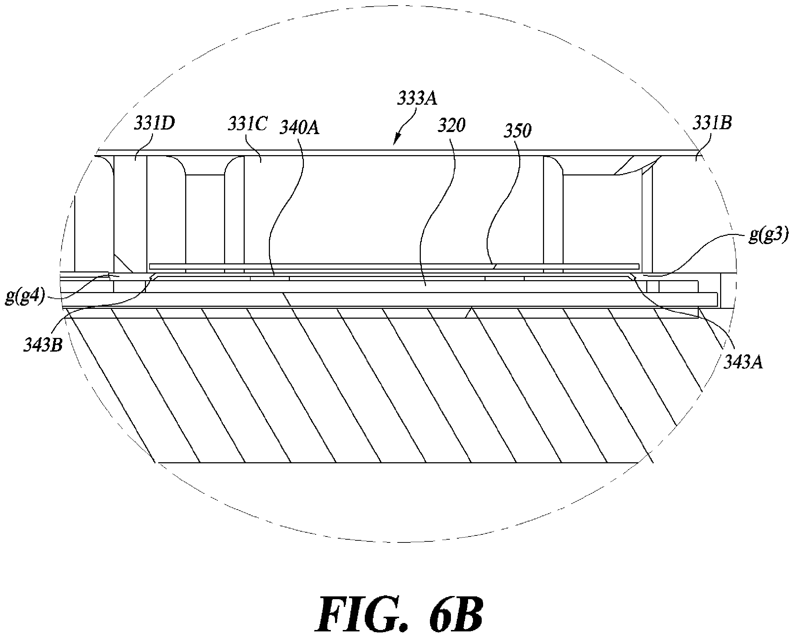

FIG. 6B is an enlarged view of a circular portion of FIG. 6A.

Referring to FIGS. 3 to 6, the lead frame 370, the substrate 320, the guide jig 330, and the like are disposed on the carrier 310. In this case, an order of the disposition is that i) the substrate 320 is disposed on the carrier 310, ii) the guide jig 330 is disposed above the upper surface of the substrate 320, iii) the preform solder 340Ais disposed on the substrate 320 through the accommodation guide hole 333, and iv) the component 350 is disposed on the preform solder 340A. In this case, at least one of a first bent portion 343A and a second bent portion 343B of the preform solder 340A comes into contact with the upper surface of the substrate 320 (see FIGS. 5, 6, and 7a).

Although the preform solder 340A (FIG. 7A) is disclosed in FIGS. 5 and 6, preform solders 340B to 340D according to FIGS. 7b to 7d can be disposed in the transfer apparatus 300 according to the second embodiment of the present disclosure, unlike FIGS. 5 and 6.

As described above, in the transfer apparatus 300 according to the second embodiment, the preform solders 340A to 340D are disposed on the upper surface of the substrate 320, and the plurality of partition walls 331 are disposed to surround the outer sides of the preform solders 340A to 340D. For example, the preform solder 340Ais disposed on the substrate 320 through the first accommodation guide hole 333A, and the preform solder 340A is surrounded by the first partition wall 331A to the fourth partition wall 331D (see FIGS. 5 and 6).

In the transfer apparatus 300 according to the second embodiment, a disposition direction of the preform solder 340A, 340B, 340C or 340D may vary depending on the type in which the substrate 320 is bent. For example, in the transfer apparatus 300 according to the second embodiment, the substrate 320 may be of a crying type and be bent so that a guide jig-substrate gap g of the first accommodation guide hole 333A and the second accommodation guide hole 333B may be larger than those of the remaining accommodation guide hole 333 disposed between the first accommodation guide hole 333A and the second accommodation guide hole 333B (this is similar to the gap d increasing from ae central portion to the outer side, as in the first embodiment of FIG. 2). In this case, as in FIGS. 5, 6, and 7a, preform solders 340A to 340D may be disposed so that a longitudinal direction of the first bent portion 343A and a longitudinal direction of the second bent portion 343B are parallel to the x-axis.

However, the preform solders 340A to 340D can be disposed so that the longitudinal direction of the first bent portion 343A and the longitudinal direction of the second bent portion 343B are parallel to the y-axis, unlike in FIGS. 5, 6, and 7a.

The transfer apparatus 300 according to the second embodiment can prevent the preform solder separation phenomenon due to the plurality of guide jig-substrate gaps g (FIGS. 5 and 6) by using the preform solder 340A, 340B, 340C or 340D including the plurality of bent portions 343 and the guide jig 330. That is, in the case of the transfer apparatus 300 according to the second embodiment, the preform solder 340A, 340B, 340C or 340D is fitted into the plurality of guide jig-substrate gaps g or does not escape to the outside of the accommodation guide hole 333 through the plurality of guide jig-substrate gaps g. This is because the preform solder 340A, 340B, 340C or 340D including the plurality of bent portions 343 has a higher height h (FIG. 7A) than the preform solder 140 of which the body is not bent.

Each of the plurality of guide jig-substrate gaps g refers to a gap between the guide jig 330 and the substrate 320 which are spaced apart from each other with a vertical direction (the z-axis in FIG. 3, FIG. 4, FIG. 5A, FIG. 5B, FIG. 6A and FIG. 6B) as a reference, and the plurality of guide jig-substrate gaps g include first to fourth guide jig-substrate gaps g4, and the like. The first guide jig-substrate gap g1 refers to a gap between the first partition wall 331A and the substrate 320. The second guide jig-substrate gap g2 refers to a gap between the third partition wall 331C and the substrate 320. The third guide jig-substrate gap g3 refers to a gap between the second partition wall 331B and the substrate 320. The fourth guide jig-substrate gap g4 refers to a gap between the fourth partition wall 331D and the substrate 320.

FIGS. 7A to 7D are diagrams schematically illustrating various embodiments of a preform solder according to the present invention.

Referring to FIGS. 7A to 7D, the preform solders 340A to 340D are disposed between the upper surface of the substrate 320 and a lower surface of the component 350. The preform solders 340A to 340D may include the plurality of bent portions 343.

The plurality of bent portions 343 may include the first bent portion 343A formed adjacent to one end of the body 341, the second bent portion 343B formed adjacent to the other end of the body 341, and the like.

FIG. 7A illustrates the same point in time as in FIG. 6A or FIG. 6B, but for convenience of description, some components of the transfer apparatus 300 according to the second embodiment are omitted, and only the substrate 320, the preform solder 340A, and the component 350 are simply illustrated.

Referring to FIG. 7A, one end of the body 341 of the preform solder 340A is formed to be inclined downwards by the first bent portion 343A. The other end of the body 341 of the preform solder 340A is formed to be inclined downwards by the second bent portion 343B. Here, at least one of the one end and the other end of the preform solder 340A may be in contact with the upper surface of the substrate 320. Here, the first bent portion 343A is bent in a (-) W direction, and the second bent portion 343B is bent in a (+) W direction. The W direction refers to a direction of rotation about the x-axis as a central axis (see FIG. 3).

At least one of the one end and the other end of the preform solder 340A may generate a frictional force due to contact with the substrate 320. For example, when the carrier 310 moves, a frictional force may be generated between the one end and/or the other end of the preform solder 340A and the upper surface of the substrate 320. Since the generated frictional force acts as a force for preventing the preform solder 340A from being moved, it is possible to effectively prevent the preform solder separation phenomenon. In particular, corner portions of the one end and the other end of the preform solder 340A are in contact with the substrate 320, and since the corner portions are relatively sharper than other portions of the preform solder 340A, the corner portions have a relatively higher surface roughness and coefficient of friction than the other portions of the preform solder 340A. That is, although only the preform solder 340A has been described above as an example, all of the preform solders 340A to 340D including the plurality of bent portions 343 can generate a relatively higher frictional force than the preform solder 140 (FIG. 2) of which the body is not bent and prevent the preform solder separation phenomenon more effectively.

The preform solders 340A to 340D may have a predetermined height h (FIG. 7A in FIG) with a vertical direction (a height direction; a z axis) as a reference. Here, the height h may be determined in consideration of the plurality of guide jig-substrate gaps g. For example, when the plurality of guide jig-substrate gaps g are larger, the height h may increase. Since the preform solders 340A to 340D have the predetermined height h, the preform solders 340A to 340D may not enter any one of the plurality of guide jig-substrate gaps g due to the movement of the carrier 310.

The height h of the preform solders 340A to 340D may be smaller than the plurality of guide jig-substrate gaps g. This is because even when the height h of the preform solders 340A to 340D is not larger than those of the plurality of guide jig-substrate gaps g, the preform solder separation phenomenon can be sufficiently prevented. Of course, it is also possible to set the height h to be larger than those of the plurality of guide jig-substrate gaps g. In addition, there is an advantage that the preform solders 340A to 340D do not enter the plurality of guide jig-substrate gaps g due to a shape of the plurality of bent portions 343.

The plurality of partition walls 331 prevent the preform solder 340A, 340B, 340C or 340D from moving due to inertia when the carrier 310 moves. Specifically, the preform solders 340A to 340D are blocked by the plurality of partition walls 331 due to the shape of the plurality of bent portions 343 and are not separated from the designated positions. The plurality of bent portions 343 of the preform solders 340A to 340D are blocked by the plurality of partition walls 331 and are not separated from the designated positions. When the carrier 310 moves, an external force in each direction of the x-axis, y-axis, and z-axis may act on the preform solders 340A to 340D due to inertia. The plurality of partition walls 331 serve to come in contact with the preform solders 340A to 340D to absorb and eliminate the external force acting on the preform solders 340A to 340D.

Since the preform solder 140 of which the body is not bent has a flat shape, there is concern that the preform solder 140 easily slides and escapes to the outside of the accommodation guide hole 333 through the plurality of guide jig-substrate gaps (g), whereas since the preform solder 340A, 340B, 340C or 340D including the plurality of bent portions 343 has a non-flat shape and the bent portion 343 prevents the preform solder 340A, 340B, 340C or 340D from being moved and/or slid in a horizontal direction (x- and y-axes), the preform solder 340A, 340B, 340C or 340D does not escape to the outside of the accommodation guide hole 333 through the plurality of guide jig-substrate gaps g. Further, the preform solder 340A, 340B, 340C or 340D is not fitted into the plurality of guide jig-substrate gaps g.

An upper surface of the preform solder 340A comes into surface contact with the lower surface of the component 350 to generate a frictional force. This frictional force acts to prevent the preform solder separation phenomenon.

Hereinafter, description of the preform solders 340B to 340D shown in FIGS. 7B to 7D will be supplemented. However, description of portions that are the same as or similar to those of the preform solder 340A described in FIG. 7A, portions having the same principle, and portions that may be naturally derived by the description of FIG. 7A will be omitted, and differences will be mainly described.

FIG. 7B will be described. Referring to FIG. 7B, one end of the body 341 of the preform solder 340B is formed to be inclined downwards by the first bent portion 343A. The other end of the body 341 of the preform solder 340B is formed to be inclined upwards by the second bent portion 343B. A central portion of the body 341 of the preform solder 340B is not parallel to the substrate 320 and the component 350. The preform solder 340B is configured such that four corners generate a frictional force. That is, two of the corners come into contact with the substrate 320, and the other two corners come into contact with the component 350. This frictional force acts to prevent the preform solder separation phenomenon.

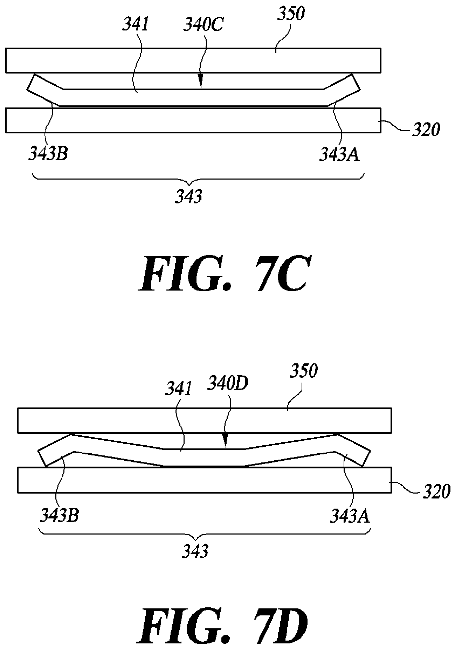

FIG. 7C will be described. Referring to FIG. 7C, one end of the body 341 of the preform solder 340C is formed to be inclined upwards by the first bent portion 343A. The other end of the body 341 of the preform solder 340C is formed to be inclined upwards by the second bent portion 343B. Here, at least one of the one end and the other end of the preform solder 340C may come into contact with an upper surface of the component 350.

FIG. 7D will be described. Referring to FIG. 7D, a central portion of the body 341 of the preform solder 340D is configured to be in surface contact with the substrate 320. One end of the body 341 of the preform solder 340D is formed to be inclined downwards by the first bent portion 343A. The other end of the body 341 of the preform solder 340D is formed to be inclined downwards by the second bent portion 343B. Thus, at least one of the one end of the body 341 and the other end of the body 341 comes into contact with the upper surface of the subtrate 320. For example, only the one end of the body 341 may come into contact with the upper surface of the subtrate 320. For example, only the other end of the body 341 may come into contact with the upper surface of the subtrate 320. For example, both the one end of the body 341 and the other end of the body 341 may come into contact with the upper surface of the subtrate 320. Corner portions of the one end and the other end of the preform solder 340D come into contact with the substrate 320. The preform solder 340D further includes a third bent portion and a fourth bent portion at both sides of the center of the body 341, such that the corner portions come into contact with the component 350 at two points.

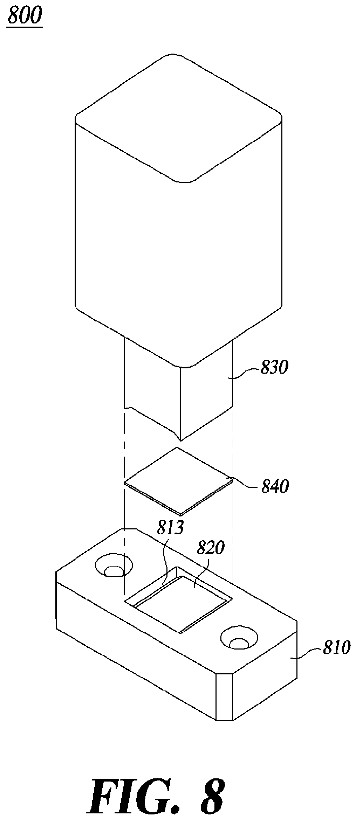

FIG. 8 is a perspective view illustrating a bending apparatus for manufacturing the preform solder of FIG. 7A.

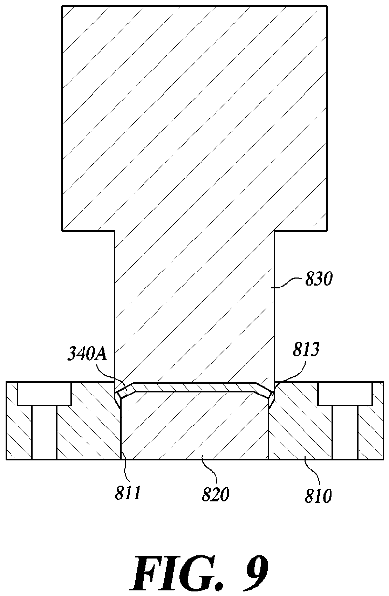

FIG. 9 is a cross-sectional view illustrating a process of manufacturing a preform solder in the bending apparatus of FIG. 8.

Referring to FIGS. 8 and 9, a bending apparatus 800 for manufacturing a preform solder may include a base 810, a press mold 820, a punch 830, and the like. The bending apparatus 800 presses a pre-bending preform solder 840 to manufacture the preform solder 340A including the first bent portion 343A and the second bent portion 343B.

The base 810 includes a base through hole 811 at a center, and a base groove portion 813 is formed along a circumference of an inner surface of the base through hole 811.

The press mold 820 is disposed in the base through hole 811. A center of an upper end portion of the press mold 820 may be formed in a horizontal direction, and both sides of the upper end portion of the press mold 820 may be formed to be inclined downwards. In this case, an angle of a downwards inclination on both the sides of the upper end portion of the press mold 820 may be 40 degrees. The pre-bending preform solder 840 is disposed in the upper end portion of the press mold 820.

The punch 830 is configured to bend both sides of the pre-bending preform solder 840 by pressing the pre-bending preform solder 840 disposed on the upper end portion of the press mold 820. A center of a lower end portion of the punch 830 may be formed in a horizontal direction, and both sides of the lower end portion of the punch 830 may be formed to be inclined downwards. In this case, an angle of downwards inclination of both the sides of the lower end portion of the punch 830 may be 40 degrees. After the punch 830 bends the pre-bending preform solder 840, the preform solder 340A is manufactured as shown in FIG. 9.

Residue and/or debris generated at the time of bending in the bending apparatus 800 are accumulated in the base groove portion 813. The bending apparatus 800 has a characteristic that an operation of repeatedly pressing the pre-bending preform solder 840 during a short period of time must be repeated. The base groove portion 813 is formed so that the residue and/or debris generated at the time of bending are naturally accumulated, and serves to prevent the residues and/or debris from adversely affecting a process of manufacturing the preform solder 740A. When the base groove portion 813 does not exist, the residue and/or debris must be periodically removed after a bending work is stopped for a while, and then the bending work must be continued, and therefore, there is concern that a time and cost of the manufacturing process may increase. That is, there is an effect that the time and cost of the manufacturing process are reduced by the base groove portion 813.

Various implementations of systems and techniques described herein may be realized as digital electronic circuits, integrated circuits, field programmable gate arrays (FPGAs), application specific integrated circuits (ASICs), computer hardware, firmware, software, and/or combinations thereof. These various implementations may include one or more computer programs executable on a programmable system. The programmable system includes at least one programmable processor (which may be a special-purpose processor or a general-purpose processor) coupled to receive and transmit data and instructions from and to a storage system, at least one input device, and at least one output device. The computer programs (also known as programs, software, software applications or codes) contain commands for a programmable processor and are stored in a "computer-readable recording medium".

The computer-readable recording medium includes all types of recording devices in which data readable by a computer system is stored. Such a computer-readable recording medium may be a non-volatile or non-transitory medium, such as ROM, CD-ROM, magnetic tape, floppy disk, memory card, hard disk, magneto-optical disk, or a storage device, and may further include a transitory medium such as a data transmission medium. In addition, the computer-readable recording medium may be distributed in a computer system connected via a network, so that computer-readable codes may be stored and executed in a distributed manner.

Various implementations of systems and techniques described herein may be embodied by a programmable computer. Here, the computer includes a programmable processor, a data storage system (including volatile memory, non-volatile memory, or other types of storage systems, or combinations thereof) and at least one communication interface. For example, the programmable computer may be one of a server, a network device, a set top box, an embedded device, a computer expansion module, a personal computer, a laptop, a personal data assistant (PDA), a cloud computing system, or a mobile device.

Although exemplary embodiments of the present disclosure have been described for illustrative purposes, those skilled in the art will appreciate that various modifications, additions, and substitutions are possible, without departing from the idea and scope of the claimed invention. Therefore, exemplary embodiments of the present disclosure have been described for the sake of brevity and clarity. The scope of the technical idea of the present embodiments is not limited by the illustrations. Accordingly, one of ordinary skill would understand that the scope of the claimed invention is not to be limited by the above explicitly described embodiments but by the claims and equivalents thereof.

## Claims

1. A transfer apparatus for semiconductor manufacturing, the transfer apparatus comprising:
a carrier configured to move;
a substrate disposed on the carrier;
a guide jig disposed above an upper surface of the substrate, the guide jig including a plurality of partition walls and a plurality of accommodation guide holes partitioned by the plurality of partition walls; and
a preform solder disposed on the upper surface of the substrate, the preform solder including a plurality of bent portions, wherein
the plurality of bent portions include
a first bent portion formed adjacent to one end of a body of the preform solder; and
a second bent portion formed adj acent to the other end of the body of the preform solder.

2. The transfer apparatus of claim 1, wherein
the one end of the body of the preform solder is formed to be inclined downwards by the first bent portion, and
the other end of the body of the preform solder is formed to be inclined downwards by the second bent portion.

3. The transfer apparatus of claim 1, wherein
the one end of the body of the preform solder is formed to be inclined downwards by the first bent portion, and
the other end of the body of the preform solder is formed to be inclined upwards by the second bent portion.

4. The transfer apparatus of claim 2, wherein at least one selected from the group of the one end and the other end comes into contact with the upper surface of the substrate.

5. The transfer apparatus of claim 4, wherein at least one selected from the group of the one end and the other end generates friction with the upper surface of the substrate when the carrier moves, to prevent the preform solder from moving due to inertia.

6. The transfer apparatus of any one of claims 1 to 5, wherein the upper surface of the substrate includes a plurality of dimples disposed to surround the preform solder.

7. The transfer apparatus of any one of claims 1 to 6, wherein each of the plurality of partition walls and the substrate are disposed to be spaced apart from each other in a vertical direction to form a plurality of guide jig-substrate gaps.

8. The transfer apparatus of claim 7, wherein the preform solder has a predetermined height in the vertical direction so that the preform solder does not move due to inertia and enter any one of the plurality of guide jig-substrate gaps when the carrier moves.

9. The transfer apparatus of any one of claims 6 to 8, wherein the plurality of partition walls prevent the preform solder from moving due to inertia when the carrier moves.

10. The transfer apparatus of any one of claims 1 to 9, wherein
the first bent portion and the second bent portion are bent by a bending apparatus and formed, and
the bending apparatus includes
a base including a base through hole formed at a center, and a base groove portion formed along a circumference of an inner surface of the base through hole;
a press mold disposed in the base through hole and including a center of an upper end portion formed in a horizontal direction and both sides of the upper end portion formed to be inclined downwards; and
a punch including a center of a lower end portion formed in a horizontal direction and both sides of the lower end portion formed to be inclined downwards, and configured to bend both sides of a pre-bending preform solder disposed in the upper end portion of the press mold.
